# EUROPÄISCHE PATENTSCHRIFT

(11) **EP 1 282 155 B1**
(45) Veröffentlichungstag und Bekanntmachung des Hinweises auf die Patenterteilung: **22.03.2006**
(21) Anmeldenummer: 01202921.1
(22) Anmeldetag: 30.07.2001
(51) Int. Cl.: H01L 21/00, H05K 13/04

(54) **Vorrichtung zum Transportieren und Bestücken von Substraten mit Halbleiterschips**
Apparatus for transporting and placing substrates comprising semiconductor chips
Dispositif pour le transport et l'équipement de substrats comprenant des puces semiconductrices

(43) Veröffentlichungstag der Anmeldung: 05.02.2003
(73) Patentinhaber: Esec Trading S.A., 6330 Cham (CH)
(72) Erfinder: Suter, Guido, 6312 Steinhausen (CH); Kellenberger, Daniel, 6003 Luzern (CH)
(74) Vertreter: Falk, Urs

(56) Entgegenhaltungen:
- US-A- 5 372 972
- US-A- 5 495 661
- US-A- 5 547 511
- US-A- 6 053 234

## Beschreibung

Die Erfindung betrifft eine Vorrichtung zum Transportieren und Bestücken von Substraten mit Halbleiterchips.

Bei der Montage von Halbleiterchips ist es gebräuchlich, die Halbleiterchips, hauptsächlich Leistungshalbleiter, mit dem Substrat mittels Weichlötung zu verbinden, um über die Lötverbindung eine wirksame Ableitung der beim Betrieb entstehenden Verlustwärme aus dem Halbleiterchip zu gewährleisten.

Als Substrate werden vorwiegend metallische Substrate, sogenannte Leadframes verwendet, wo die Halbleiterchips auf hintereinander und, fakultativ, nebeneinander angeordneten Chipinseln aufgelötet werden. Das Leadframe wird taktweise einer Lotstation, wo das Lot aufgetragen wird, und dann einer Bondstation zugeführt, wo der Halbleiterchip von einem Pick and Place System auf dem flüssigen Lot plaziert wird. Das Leadframe weist entlang seiner Längskanten angeordnete Löcher auf, in die beim Transport des Leadframes Stifte eingreifen. Ein für diesen Prozess geeigneter Die Bonder wird von der Anmelderin unter der Bezeichnung 2007 SSI vertrieben.

Als Substrate kommen aber auch Einzelplatzsubstrate, sogenannte singulated substrates, zur Anwendung. Ein solches Einzelplatzsubstrat besteht beispielsweise aus einem Keramikplättchen, das beidseitig mit einer Metallschicht bedeckt ist. Die Montage der Halbleiterchips erfolgt manuell, wobei zuerst eine vorgeformte Lotportion, eine sogenannte solder preform, auf das Einzelplatzsubstrat aufgelegt und dann der Halbleiterchip auf die Lotportion aufgelegt wird. Anschliessend wird der ganze Verbund in einem Ofen verlötet. Bekannt ist auch ein halbautomatisches Montageverfahren, bei dem anstelle einer vorgeformten Lotportion maschinell pastenförmiges Lot auf das Einzelplatzsubstrat aufgetragen wird. Anschliessend werden die Einzelplatzsubstrate manuell mit dem Halbleiterchip bestückt und wiederum in einem Ofen verlötet.

US 5 372 972 beschreibt eine Vorrichtung zum Transportieren und Bestücken von Substraten mit Halbleiterchips, mit einem Kanal, indem die Substrate in einer Transportrichtung transportiert werden.

Der Erfindung liegt die Aufgabe zugrunde, eine Vorrichtung zu entwickeln, mit der Einzelplatzsubstrate vollautomatisch bestückt werden können.

Die genannte Aufgabe wird erfindungsgemäss gelöst durch die Merkmale des Anspruchs 1.

Eine erfindungsgemässe Vorrichtung zum Transportieren und Bestücken von Einzelptatzsubstraten mit Halbleiterchips weist einen Kanal mit zwei Seitenwänden auf in dem die Einzelplatzsubstrate in einer Transportrichtung transportiert werden. Der Vorschub der Einzetplatzsubstrate erfolgt mittels mit Zähnen versehenen, heb- und senkbaren und hin und her bewegbaren Kämmen, wobei jeder Zahn ein Einzelplatzsubstrat vorwärts schiebt. In der einen Seitenwand des Kanals federnd gelagerte Elemente bewirken, dass die Einzelplatzsubstrate gegen die andere Seitenwand gedrückt werden, so dass sie von der im Kanal herrschenden Strömung des Schutzgases nicht mitgerissen werden.

Die Vorrichtung kann auch für den Transport von Leadframes eingerichtet werden.

Nachfolgend werden Ausführungsbeispiele der Erfindung anhand der nicht massstäblichen Zeichnung näher erläutert.

Es zeigen:
- Fig. 1: eine Vorrichtung zum Bestücken von Einzelplatzsubstraten in Aufsicht,
- Fig. 2: die Vorrichtung in einem Schnitt quer zu einer Transportrichtung,
- Fig. 3A, B: verschiedene Phasen des Transportvorganges, und
- Fig. 4: eine Vorrichtung zum Bestücken von Leadframes in Aufsicht.

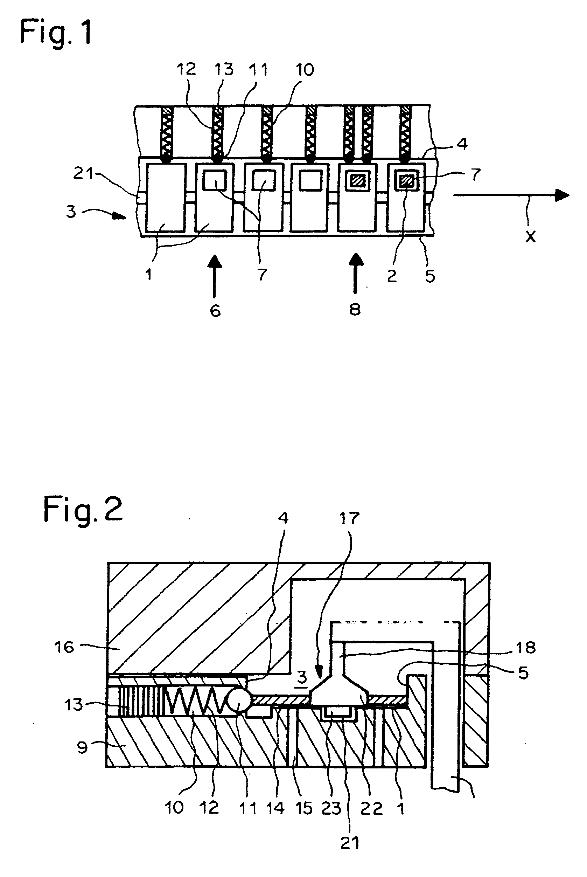

Die Fig. 1 zeigt eine Vorrichtung zum Bestücken von Einzelplatzsubstraten 1 mit Halbleiterchips 2. Die Einzelplatzsubstrate 1 werden in einem rechteckförmigen Kanal 3 mit zwei Seitenwänden 4 und 5 taktweise in einer Transportrichtung x transportiert. An einer Lotstation 6 wird eine Lotportion 7 aufgebracht, beispielsweise gemäss dem in der europäischen Patentanmeldung EP 852983 beschriebenen Verfahren. Anschliessend wird an einer Bondstation 8 ein Halbleiterchip 2 auf die Lotportion 7 abgesetzt. Im Kanal 3 wird mit nicht dargestellten Mitteln ein vorbestimmtes Temperaturprofil erzeugt, damit der Halbleiterchip 2 über die Lotportion 7 mit dem Einzelplatzsubstrat 1 verlötet wird.

Die Fig. 2 zeigt den Kanal 3 im Querschnitt quer zur Transportrichtung x. Der Kanal 3 ist als rechteckförmige Vertiefung in einer auswechselbaren metallischen Platte 9 gebildet. Die metallische Platte 9 ist mit in periodischen Abständen angeordneten Bohrungen 10 versehen, die quer zur Transportrichtung x verlaufen und in die Seitenwand 4 des Kanals 3 münden. Die andere Seitenwand 5 des Kanals 3 ist als ebene Fläche ausgebildet. Jede Bohrung 10 enthält eine Kugel 11, eine Feder 12 und eine kopflose Schraube 13. Die Bohrung 10 ist auf der der Seitenwand 4 zugewandten Seite verengt, so dass die Kugel 11 nicht aus der Bohrung 10 herausfallen kann. Die Feder 12 drückt die Kugel 11 gegen die Seitenwand 4, wobei die Kugel 11 aus der Bohrung 10 heraus in den Kanal 3 ragt. Wenn ein Einzelplatzsubstrat 1 in den Bereich der Kugel 11 gelangt, dann drückt die federnd gelagerte Kugel 11 einerseits das Einzelplatzsubstrat 1 gegen die Seitenwand 5, andererseits drückt das an der Seitenwand 5 zum Anschlag gebrachte Einzelplatzsubstrat 1 die Kugel 11 in die Bohrung 10 hinein. Über in seinem Boden 14 angebrachte Bohrungen 15 wird der Kanal 3 mit einem Schutzgas beaufschlagt. Das Schutzgas strömt im Kanal 3 in Transportrichtung x. Der Kanal 3 ist gegen oben mit einer Platte 16 abgedeckt. Die Platte 16 ist allerdings im Bereich der Lotstation 6 und im Bereich der Bondstation 8 offen.

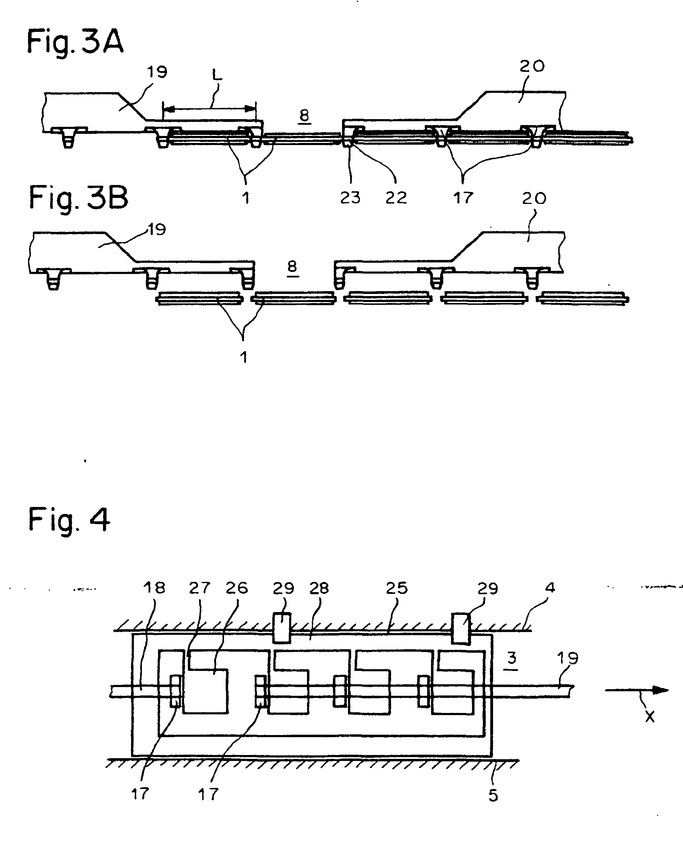

Die Einzelplatzsubstrate 1 werden von drei mit Zähnen 17 versehenen Kämmen 18, 19 und 20 taktweise in Transportrichtung x vorgeschoben. (Die Kämme 19 und 20 sind nur in den Fig. 3A und 3B dargestellt.) Der erste Kamm 18 transportiert die Einzelplatzsubstrate 1 bis zur Lotstation 6 (Fig. 1), wo das Lot aufgebracht wird. Der zweite Kamm 19 transportiert die Einzelplatzsubstrate 1 von der Lotstation 6 zur Bondstation 8, wo der Halbleiterchip auf die Lotportion abgesetzt wird. Der dritte Kamm 20 transportiert die Einzelplatzsubstrate 1 weiter bis zum Ende des Kanals 3. Die Einzelplatzsubstrate 1 liegen auf dem Boden 14 des Kanals 3 auf und werden mittels der federnd gelagerten Kugeln 11 scitlich festgehalten, so dass die Strömung des Schutzgases sie nicht mitreisst.

Der Boden 14 des Kanals 3 weist eine etwa in der Mitte angeordnete, in Transportrichtung x verlaufende Nut 21 auf. Die Zähne 17 weisen Flügel 22 auf, die auf dem Boden 14 des Kanals 3 zur Auflage kommen, während ein Fortsatz 23 der Zähne 17 in die Nut 21 hineinragt. Der Fortsatz 23 ist gegen seine Spitze verjüngt ausgebildet.

Für den taktweisen Vorschub der Einzelplatzsubstrate 1 werden die drei Kämme 18, 19 und 20 von einem gemeinsamen Antriebsmechanismus 24 gemäss dem in den Fig. 3A und 3B gezeigten Ablauf betätigt. Zu Beginn eines Taktes befinden sich die Kämme 18, 19 und 20 in einer abgesenkten Position, in der die Zähne 17 der Kämme 18, 19 und 20 zwischen den Einzelplatzsubstraten 1 eingreifen (Fig. 3A) und in der deren Flügel 22 auf dem Boden 14 des Kanals 3 aufliegen. Vorgängig zur eigentlichen Montagephase werden die Kämme 18, 19 und 20 in dieser Position und im aufgeheizten Zustand der Vorrichtung gegenseitig so justiert, dass die Lage des Einzelplatzsubstrates 1, das sich an der Bondstation befindet, vom ersten Zahn 17 des zweiten Kammes 19 und vom letzten Zahn 17 des dritten Kammes 20 praktisch spielfrei definiert ist. In dieser Position wird nun das Einzelplatzsubstrat 1 an der Bondstation mit einem Halbleiterchip bestückt, und es wird am Eingang des Kanals 3 ein neues Einzelplatzsubstrat 1 eingeführt und vorgeschoben, bis es am hintersten Zahn 17 des ersten Kammes 18 anstösst. Auf diese Weise wird sein Abstand zum vorderen Einzelplatzsubstrat 1 definiert. Anschliessend werden die drei Kämme 18, 19 und 20 angehoben (Fig. 3B), um eine Vorschublänge L rückwärts bewegt, wieder abgesenkt, wobei die verjüngt ausgebildeten Fortsätze 23 der Zähne 17 in die Zwischenräume zwischen den Einzelplatzsubstraten 1 eingreifen, und im abgesenkten Zustand um die Vorschublänge L vorgeschoben. Dabei schieben die Zähne 17 die Einzelplatzsubstrate 1 in Transportrichtung x vor, wobei die Einzelplatzsubstrate 1 auf dem Boden des Kanals 3 gleiten. Wenn die Kämme 18, 19 und 20 angehoben sind (Fig. 3B), werden die Einzelplatzsubstrate 1 von den federnd gelagerten Kugeln 11 gegen die Seitenwand 5 gedrückt und somit in ihrer Position festgehalten. Die Einzelplatzsubstrate 1 sind als beidseitig mit einer elektrisch leitenden Schicht beschichtete Keramikplättchen dargestellt.

Bei einer typischen Abmessung der Einzelplatzsubstrate 1 von 3 - 5 cm haben sich Flügel 22 mit einer Breite von 4 - 8 mm bewährt, so dass die Einzelplatzsubstrate 1 beim Vorschub nicht verkanten. Die Bohrungen 10 sind im Abstand der Vorschublänge L angeordnet. D.h. dass im abgehobenen Zustand der Kämme 18 - 20 jedes Einzelplatzsubstrat 1 mittels einer federnd gelagerten Kugel 11 festgehalten wird. An der Bondstation 8 sind jedoch bevorzugt zwei Bohrungen 10 mit Kugeln 11 vorhanden, damit das zu bestückende Einzelplatzsubstrat 1 plan gegen die Seitenwand 5 gedrückt wird.

Die Fig. 4 zeigt eine für den Vorschub von Leadframes 25 ausgebildete Vorrichtung, soweit es für das Verständnis der Erfindung erforderlich ist. Jedes Leadframe 25 enthält mehrere hintereinanderangeordnete Chipinseln 26, die über mindestens einen Steg 27 mit dem Rahmen 28 des Leadframes 25 verbunden sind. Die Zähne 17 der Kämme 18, 19 und 20 (nicht dargestellt) greifen bei den Chipinseln 26 an und schieben somit die Chipinseln 26 vorwärts. Damit das Leadframe 25 im angehobenen Zustand der Kämme 18, 19 und 20 von der im Kanal 3 herrschenden Gasströmung nicht mitgezogen wird, sind federnd gelagerte Rollen 29 vorgesehen, die den Rahmen 28 des Leadframes 25 gegen den Boden des Kanals 3 drücken.

## Patentansprüche

1. Vorrichtung zum Transportieren und Bestücken von Substraten (1; 25) mit Halbleiterchips (2), mit einem Kanal (3), in dem die Substrate (1; 25) in einer Transportrichtung (x) transportiert werden, **dadurch gekennzeichnet, dass** der Kanal (3) zwei Seitenwände (4, 5) aufweist, dass mindestens ein heb- und senkbarer Kamm (18; 19; 20) vorhanden ist, um die Substrate (1; 25) in Transportrichung (x) zu schieben, und dass federnd gelagerte Element (11; 29) vorhanden sind, die gegen die Substrate (1; 25) drücken.

2. Vorrichtung nach Anspruch 1, **dadurch gekennzeichnet, dass** die federnd gelagerten Elemente (11) in einer Seitenwand (4) des Kanals (3) gelagert sind, so dass sie die Substrate (1) gegen die andere Seitenwand (5) drücken.

3. Vorrichtung nach Anspruch 1, **dadurch gekennzeichnet, dass** die federnd gelagerten Elemente (11) die Substrate (25) gegen den Boden (14) des Kanals (3) drücken.

4. Vorrichtung nach einem der Ansprüche 1 bis 3, **dadurch gekennzeichnet, dass** drei Kämme (18; 19; 20) vorhanden sind, wobei der erste Kamm (18) die Substrate (1; 25) bis zu einer Lotstation (6) transportiert, wobei der zweite Kamm (19) die Substrate (1; 25) von der Lotstation (6) zu einer Bondstation (8) transportiert, und wobei der dritte Kamm (20) die Substrate (1; 25) von der Bondstation (8) weg transportiert.

## Revendications

1. Dispositif pour le transport et l'approvisionnement de substrats (1; 25) avec des puces semi-conducteurs (2), avec un canal (3) dans lequel les substrats (1; 25) sont transportés dans une direction de transport (x), **caractérisé en ce que** le canal (3) présente deux parois latérales (4, 5), **en ce qu'**au moins un peigne susceptible (18; 19; 20) d'être levé et baissé est présent pour pousser les substrats (1; 25) dans la direction de transport (x), et **en ce que** des éléments (11; 29) logés de façon élastique sont présents qui poussent contre les substrats (1; 25).

2. Dispositif selon la revendication 1, **caractérisé en ce que** les éléments (11) logés de façon élastique sont logés dans une paroi latérale (4) du canal (3) de manière à ce que les substrats (1) poussent contre l'autre paroi latérale (5).

3. Dispositif selon la revendication 1, **caractérisé en ce que** les éléments (11) logés de façon élastique poussent les substrats (25) contre le fond (14) du canal (3).

4. Dispositif selon une des revendications 1 à 3, **caractérisé en ce que** trois peignes (18; 19; 20) sont présents; le premier peigne (18) transportant les substrats (1; 25) jusqu'à une station de brasage (6); le deuxième peigne (19) transportant les substrats (1; 25) de la station de brasage (6) jusqu'à une station de mise en liaison (8), et où le troisième peigne (20) enlève les substrats (1; 25) de la station de mise en liaison.

## Claims

1. Apparatus for the transport and equipping of substrates (1; 25) with semiconductor chips (2), with a channel (3) in which the substrates (1; 25) are transported in a transport direction (x), **characterised in that** the channel (3) has two side walls (4, 5), that at least one comb (18; 19; 20) which can be raised and lowered is present in order to feed the substrates (1; 25) in the transport direction (x), and that resiliently mounted elements (11; 29) are present which press against the substrates (1; 25).

2. Apparatus according to claim 1, **characterised in that** the resiliently mounted elements (11) are supported in one side wall (4) of the channel (3) so that they press the substrates (1) against the other side wall (5).

3. Apparatus according to claim 1, **characterised in that** the resiliently mounted elements (11) press the substrates (25) against the floor (14) of the channel (3).

4. Apparatus according to any of claims 1 to 3, **characterised in that** three combs (18; 19; 20) are present whereby the first comb (18) transports the substrates (1; 25) as far as a soldering station (6), whereby the second comb (19) transports the substrates (1; 25) from the soldering station (6) to a bonding station (8), and whereby the third comb (20) transports the substrates (1; 25) away from the bonding station (8).
